# EUROPÄISCHE PATENTSCHRIFT

(11) **EP 2 370 997 B1**
(45) Veröffentlichungstag und Bekanntmachung des Hinweises auf die Patenterteilung: **24.02.2016**
(21) Anmeldenummer: 09760882.2
(22) Anmeldetag: 30.11.2009
(51) Int. Cl.: H01L 21/68, B32B 37/10, B32B 37/12, H01L 21/67, H01L 21/683

(54) **BONDING-VERFAHREN**
BONDING METHOD
PROCÉDÉ DE LIAISON

(30) Priorität: 28.11.2008 DE 102008044200
(43) Veröffentlichungstag der Anmeldung: 05.10.2011
(73) Patentinhaber: Thin Materials GmbH, 82223 Eichenau (DE)
(72) Erfinder: RICHTER, Franz, 82223 Eichenau (DE)
(74) Vertreter: Eisenführ Speiser
(86) Internationale Anmeldenummer: PCT/EP2009/066058
(87) Internationale Veröffentlichungsnummer: WO 2010/061004

(56) Entgegenhaltungen:
- DE-A1- 10 048 881
- JP-A- 2008 118 029
- US-A1- 2005 221 598
- US-A1- 2006 292 887
- GREGORY A LUURTSEMA: "SPIN COATING FOR RECTANGULAR SUBSTRATES" THESIS,, [Online] 11. Juli 1997 (1997-07-11), Seite 39PP, XP007911928 Gefunden im Internet: URL:http://bcam.berkeley.edu/ARCHIVE/these s/gluurtsMS.pdf> [gefunden am 2010-02-25]
- "Spin Coating Theory" [Online] 3. August 2008 (2008-08-03), 20080803 , XP007911900 Gefunden im Internet: URL:http://web.archive.org/web/20080803051 133/http://www.ece.gatech.edu/r esearch/labs/vc/packaging/theory/spin_theo ry.html> [gefunden am 2010-02-24]

## Beschreibung

Die Erfindung betrifft ein Verfahren zum Bonden (Verbinden) einer ersten Fläche und einer zweiten Fläche mittels einer Zwischenschicht, wobei das Material für die Zwischenschicht in einem fließfähigen Zustand eine Aufwölbung bildet und deren positive Eigenschaften für das Bonden ausgenutzt werden.

Das Verbinden von Flächen spielt bei einer Vielzahl von Anwendungen eine Rolle. So werden beispielsweise Schichten in Verbundsystemen auflaminiert oder Schutzfolien auf zu schützende Oberflächen aufgebracht. Für viele Anwendungen wie zum Beispiel in der Wafer-Bearbeitung für die Halbleiterindustrie ist es entscheidend, beim Bonden Exaktheit zum Beispiel bei der Ausrichtung der zu verbindenden Flächen zueinander oder bei der Einstellung der nach dem Bonden bestehenden Haftkraft zu erreichen.

So werden mit dem Ziel, Wafer für nachfolgende Bearbeitungsschritte wie das Rückseitenmetallisieren oder ein Abdünnen zu schützen, Schutzschichten und/oder unterstützende Schichten im Bereich der Seite mit den elektronischen Bauelementen vorgesehen. Diese Schichten haben die Funktion, den zu bearbeitenden Wafer zu stabilisieren und auf der zu schützenden Seite vor mechanischen Belastungen zu bewahren. Hierzu werden häufig als kreisförmige Scheiben ausgebildete Substrate, wie zum Beispiel ein weiterer Wafer oder eine Glasscheibe die den zu bearbeitenden Wafer stabilisiert (auch im nachbearbeiteten z.B. gedünnten Zustand), über eine Zwischenschicht mit dem zu bearbeitenden Wafer verbunden. Die Zwischenschicht kann beispielsweise aus einem Kleber oder aus polymerem Material bestehen. Häufig erfolgt das Bonden unter mechanischem Druck um zum Beispiel um einen Formschluss zu gewährleisten und/oder unter Wärmeeinwirkung, um eine Verbindung zum Beispiel über eine chemische Veränderung der Zwischenschicht zu ermöglichen.

Ein Verfahren und eine Vorrichtung zum Bonden von Wafern ist beispielweise aus der AT 504 567 A2 bekannt. Hierbei werden die zu verbindenden Flächen (die zu bondenden Flächen) über Druckplatten aneinander gepresst, wobei gleichzeitig oder nachfolgend eine Hitzeeinwirkung auf das zu bondende Material erfolgt.

Hierbei ist der apparative Aufwand problematisch, ebenso ist es schwierig zu gewährleisten, dass die Druckweinwirkung tatsächlich auf der gesamten Fläche völlig gleichmäßig erfolgt. Hinzu kommt, dass verhältnismäßig hohe Drücke auf die zu bondenden Gegenstände ausgeübt werden, so dass eine hohe mechanische Belastung besteht und darüber hinaus eine thermische Belastung notwendig ist.

Weitere Verfahren und Vorrichtungen zum Bonden von Substraten sind aus US-A-2005221598, US-A-2006292887, DE-A-10048881 und JP-A-2008118029 bekannt.

Vergleichbare Probleme treten bei den im Stand der Technik bislang bekannten Bonding-Verfahren auf.

Aufgabe der vorliegenden Erfindung war es, ein Bonding-Verfahren anzugeben, bei dem eine möglichst gleichmäßige Druckausübung im gesamten Bereich der zu bondenden Flächen gewährleistet ist. Darüber hinaus sollte das Verfahren dazu geeignet sein, eine möglichst hohe Parallelität der zu bondenden Flächen ohne großen apparativen Aufwand zu ermöglichen.

Diese Aufgabe wird gelöst durch ein Verfahren zum Bonden einer ersten Fläche und einer zweiten Fläche mittels einer Zwischenschicht, umfassend die Schritte:
a) Bereitstellen eines ersten Gegenstandes mit der ersten Fläche,
b) Bereitstellen von fließfähigem, verfestigbarem Material für die Zwischenschicht,
c) Bereitstellen eines zweiten Gegenstandes mit der zweiten Fläche,
d) Auftragen des Materials für die Zwischenschicht auf die erste Fläche, so dass eine die Fläche umlaufende Aufwölbung entsteht,
e) Anlegen eines Vakuums um den ersten Gegenstand und den zweiten Gegenstand,
f) Kontaktieren der zweiten Fläche des zweiten Gegenstandes mit der umlaufenden Aufwölbung, so dass ein abgeschlossener Hohlraum entsteht,
g) Erhöhen des Umgebungsdruckes, so dass der Hohlraum aufgehoben wird (das heißt, so dass das Volumen des Hohlraumes gegen Null geht, bevorzugt vollständig beseitigt wird), ohne dass es zu einem Gaseinstrom in ihn kommt und
h) Erhöhen der Viskosität des Materials für die Zwischenschicht.

Eine Fläche im Sinne des hier vorliegenden Textes kann auch Strukturen tragen. Insbesondere können beispielweise mikroelektronischen Elemente als Strukturierungen in der Fläche vorliegen und auch deutliche Erhöhungen wie zum Beispiel Bumps sind möglich. Bevorzugt ist die erste Fläche jedoch nicht mit Strukturen versehen und ebenfalls bevorzugt ist die zweite Fläche in dem Bereich, in dem sie mit der umlaufenden Aufwölbung kontaktiert wird, ebenfalls nicht mit Strukturen versehen, also jeweils im Wesentlichen eben.

Unter fließfähigem Material ist im Sinne dieser Anmeldung ein Material zu verstehen, das unter den Temperatur- und Druckbedingungen beim Auftragen in einem fließfähigen Zustand ist.

Ein verfestigbares Material im Sinne dieser Anmeldung ist ein Material, bei dem durch chemische Reaktion bevorzugt durch Polymerisierung oder jede andere Maßnahme wie ein Absenken der Temperatur (in diesem Fall aber ohne Aggregatwechsel), eine Erhöhung der Viskosität bis hin zur gegebenenfalls vollständigen Verfestigung erfolgen kann oder ein Wachs.

Unter einer umlaufenden Aufwölbung ist im Sinne dieser Anmeldung ein erhöhter Rand im lateralen Bereich der Schicht zu verstehen, die aus dem Material für die Zwischenschicht nach dem Auftragen auf die erste Fläche gebildet wurde. Die Erhöhung ist dabei senkrecht zur Ebene der ersten Fläche zu verstehen. Umlaufend heißt in diesem Zusammenhang, dass der gesamte Randbereich der Schicht betroffen ist, also eine im Umfang geschlossene Aufwölbung besteht.

Ein abgeschlossener Hohlraum im Sinne dieser Anmeldung ist ein Hohlraum, bei dem ein Gasaustausch mit der Umgebung nicht erfolgt.

Ein Vakuum im Sinne dieser Anmeldung ist ein technisches Vakuum mit einem maximalen Druck bevorzugt von 100, bevorzugt 50, weiter bevorzugt 10, besonders bevorzugt 1, ganz besonders bevorzugt 0,2 mbar. Unter Umgebungsdruck ist im Sinne dieser Anmeldung ein Druck zu verstehen, der im Wesentlichen gleichmäßig auf das gesamte zu bondende System einwirkt. Insbesondere ist unter dem Umgebungsdruck der Atmosphärendruck zu verstehen.

Für das erfindungsgemäße Verfahren ist es sinnvoll, die erste Fläche parallel zur Erdoberfläche auszurichten. Der Auftrag des Materials für die Zwischenschicht kann mit einer Reihe von Auftragsverfahren erfolgen.

Bevorzugte Verfahren zum Auftragen des Materials für die Zwischenschicht sind Rakeln, Aufsprühen, insbesondere Spraycoating, Auftragen durch Abscheiden aus Suspension und insbesondere Spincoating.

Bei dem besonders bevorzugten Spincoating (Aufschleudern) des Materials für die Zwischenschicht wird dieses Material mittels einer geeigneten Einrichtung auf den Träger aufgebracht, wobei dieser hierbei oder nachfolgend so in Rotation gebracht wird, dass die entstehenden Zentrifugalkräfte das Material von der Mitte zum Rand des Trägers treiben und somit flächig verteilen. Bevorzugt wird dieses Verfahren so durchgeführt, dass das Material für die Zwischenschicht mit einer hohen Gleichmäßigkeit der Dicke über der ersten Fläche aufgebracht wird. Auch ist es möglich mittels dieses Verfahrens gewisse Flächenunebenheiten der ersten Fläche auszugleichen, da das Material für die Zwischenschicht ja fließfähig ist. Dem Fachmann ist es in diesem Zusammenhang unschwer möglich, das Material für die Zwischenschicht so auszuwählen, dass es Benetzungseigenschaften gegenüber der ersten Fläche besitzt, die dazu führen, dass sich im Randbereich der Schicht des Materials für die Zwischenschicht eine umlaufende Aufwölbung (ein sogenannter edge bead) bildet. In diesem Bereich ist die Schichtdicke des Materials für die Zwischenschicht erhöht. Dies ist gewöhnlich unerwünscht, lässt sich aber überraschenderweise bei dem erfindungsgemäßen Verfahren vorteilhaft ausnutzen.

Dem Fachmann ist selbstverständlich klar, dass das Material für die Zwischenschicht auch eine Mischung mehrerer Materialen darstellen kann. Wichtig ist allerdings die Eigenschaft über die Fließfähigkeit eine im Wesentlichen ebene Oberfläche darzustellen, selbstverständlich mit Ausnahme der umlaufenden Aufwölbung, die ausdrücklich erwünscht ist.

Nach dem Auftragen des Materials für die Zwischenschicht auf die erste Fläche werden der erste Gegenstand und der zweite Gegenstand in ein Vakuum eingebracht. Dies erfolgt üblicherweise dadurch, dass die Gegenstände in eine Vakuumkammer gebracht werden und diese entsprechend evakuiert wird. Selbstverständlich ist es bei entsprechender apparativer Ausgestaltung auch möglich den Schritt d) bereits im Vakuum durchzuführen. Dies kann für einige Anwendungen bevorzugt sein.

Zum Bonden der ersten Fläche und der zweiten Fläche wird die zweite Fläche im Vakuum mit der umlaufenden Aufwölbung so in Kontakt gebracht, dass ein abgeschlossener Hohlraum entsteht. Hierzu ist es selbstverständlich sinnvoll, dass die zweite Fläche vor dem Kontaktieren mit der Aufwölbung parallel zur ersten Fläche ausgerichtet wird. Insbesondere wenn die Flächen gleich groß und gleich geformt sind, ist es selbstverständlich sinnvoll, die zweite Fläche vor dem Kontaktieren mit der umlaufenden Aufwölbung so zu positionieren, dass sie lateral in Deckung mit der ersten Fläche ist. Selbstverständlich kann dieser Ausrichtvorgang auch ausgeführt werden, bevor das Vakuum angelegt ist.

Beim Kontaktieren der zweiten Fläche mit der umlaufenden Aufwölbung kommt es besonders darauf an, dass die Aufwölbung voll umfänglich die zweite Fläche berührt. So entsteht zwischen der Waferoberfläche und dem Träger der gewünschte Hohlraum.

Um dies zu gewährleisten ist es oft bevorzugt, dass die Viskosität des Materials für die Zwischenschicht so hoch ist, dass die umlaufende Aufwölbung den ersten Gegenstand so trägt, dass ein Hohlraum bestehen bleibt. Dies kann z.B. dadurch erreicht werden, dass die Viskosität des Materials über die Zwischenschicht nach dem Auftragen durch geeignete Maßnahmen wie z.B. Erwärmen, Bestrahlen usw. (abhängig vom Material für die Zwischenschicht) erhöht wird, falls diese nicht ausreicht, den zweiten Gegenstand ohne die Nivellierung der umlaufenden Aufwölbung zu tragen. Alternativ oder zusätzlich ist es aber auch möglich, dass der zweite Gegenstand durch eine geeignete Vorrichtung in Position gehalten wird, so dass seine Gewichtskraft nicht vollständig auf die umlaufende Aufwölbung wirkt.

In diesem Zusammenhang sei darauf hingewiesen, dass es für die Anwendung vorteilhaft sein kann, wenn die zweite Fläche im Wesentlichen eben ist. Dies ist aber nicht unbedingt notwendig, da die Viskosität des Materials für die Zwischenschicht so eingestellt werden kann, dass auch Unebenheiten der zweiten Fläche vom Material für die Zwischenschicht aufgenommen werden. Dies bedeutet, dass Strukturierungen der zweiten Fläche in das Material der Zwischenschicht einsinken können, auch wenn der zweite Gegenstand voll umfänglich die umlaufende Aufwölbung kontaktiert. In diesem Fall kann es sein, dass mehrere getrennte Hohlräume entstehen, was aber die Vorteile der Erfindung nicht einschränkt. Entscheidend ist, wie bereits oben angedeutet, dass die umlaufende Aufwölbung vollständig in Kontakt mit der zweiten Fläche ist. Dieses ist natürlich besonders gut gewährleistet, wenn in die zweite Fläche im Bereich des Kontaktierens mit der umlaufenden Aufwölbung im Wesentlichen eben ist.

Um das Kontaktieren im Schritt f) zu bewirken stehen dem Fachmann eine Reihe von Möglichkeiten zur Verfügung: Dabei kann beispielsweise der zweite Gegenstand mittels einer geeigneten Vorrichtung so lange abgesenkt werden, bis eine ausreichende Kontaktierung vorhanden ist. Alternativ kann selbstverständlich auch der erste Gegenstand angehoben werden. Bevorzugt ist allerdings, dass der zweite Gegenstand nahe an die umlaufende Aufwölbung herangebracht wird, indem er zum Beispiel ≤ 6 mm, bevorzugt ≤ 4 mm weiter bevorzugt ≤ 1 mm senkrecht über die Aufwölbung angeordnet und gegebenenfalls noch lateral ausgerichtet wird. Danach kann er fallen gelassen werden. Hierbei ist es dem Fachmann möglich, die Fallhöhe auf in die gewünschte Druckausübung die umlaufende Aufwölbung einzustellen. Er wird dies in Abhängigkeit von der zum Zeitpunkt des Fallenlassens vorliegenden Viskosität des fließfähigen verfestigbaren Materials vornehmen.

Nach dem Kontaktieren im Schritt f) erfolgt das Erhöhen des Umgebungsdruckes zum Beispiel durch Belüften der Unterdruckapparatur. Dadurch erfolgt eine ideale gleichmäßige Druckausübung auf in die Anordnung aus erstem Gegenstand, Zwischenschicht und zweitem Gegenstand. Bevorzugt ist in diesem Zusammenhang, dass der Druck bis zu einem normalen Atmosphärendruck erhöht wird. Hierbei ist selbstverständlich darauf zu achten, dass in den abgeschlossen Hohlraum kein Gas aus der Umgebung eintreten kann. Die Druckerhöhung erfolgt zum Beispiel durch Belüften, muss aber nicht bis auf Atmosphärendruck erfolgen.

Das Belüften erfolgt so, dass der gesteigerte Umgebungsdruck bewirkt, dass der abgeschlossene Hohlraum restlos zusammengedrückt wird. Das bedeutet, dass die zweite Fläche mit dem Material für die Zwischenschicht einen Formschluss bildet. Eventuelle Unebenheiten der ersten Fläche und der zweiten Fläche sowie auftragebedingt der Zwischenschicht werden auf diese Weise durch die Fließfähigkeit des Materials der Zwischenschicht ausgeglichen. Gleichzeitig wird auch die umlaufende Aufwölbung nivelliert. Gegebenenfalls überschüssiges Material der Aufwölbung und eventuell auch der weiteren Zwischenschicht wird dabei vorzugsweise am Rand herausgepresst. Der Hohlraum kann jedoch im Grenzfall auch schon beim Auflegen der oberen Fläche verschwinden. Solange die umlaufende Aufwölbung beide Flächen gegeneinander abdichtet, wird die Anpresskraft durch die Erhöhung des Außendrucks gleichmäßig auf die Flächen wirken.

Aufgrund der Erhöhung des Umgebungsdruckes ist ein ideal gleichmäßiges Anpressen der ersten und der zweiten Fläche vermittelt durch die Zwischenschicht aneinander gewährleistet. Die Ausrichtung der beiden Flächen zueinander bleibt unverändert (selbstverständlich mit Ausnahme der senkrechten Raumrichtung), so dass eine hohe Genauigkeit hinsichtlich der Parallelität der Flächen zueinander erreicht werden kann. Durch die gleichmäßige Druckübertragung ist darüber hinaus gewährleistet, dass nicht einzelne Teile oder Bereiche eines der beiden Gegenstände stärker als gewünscht eingedrückt werden, wie zum Beispiels bei der Verwendung von Chucks oder anderen stempelähnlichen Druckübertragungsvorrichtungen passieren kann.

Das Aufheben des Hohlraums mit Vakuum kann zusätzlich durch ein Zusammenpressen der Flächen auf eine andere Art geschehen zum Beispiel durch Druckplatten oder Chucks. Es kann auch rein durch Schwerkraft erfolgen.

Nach dem Aufheben des Hohlraumes wird im Schritt h) die Viskosität des Materials für die Zwischenschicht erhöht, gegebenenfalls wird diese vollständig verfestigt. Dieses wird durch eine vom Material abhängige Vorgehensweise gewährleistet, wie zum Beispiel durch Erwärmen, Bestrahlung mittels UV oder das Auslösen einer Reaktion eines 2-Komponenten-Materials. Ebenfalls ausgetretenes Material für die Zwischenschicht kann vor dem Erhöhen der Viskosität oder auch danach entfernt werden.

Erfindungsgemäß bevorzugt ist, dass das fließfähige, verfestigbare Material ein polymerisierbares Material ist. Beispiel für solche Materialen sind: Wachse, Klebstoffe, vernetzende Kunststoffe wie z.B. Polyimide.

Besonders bevorzugt ist eine erfindungsgemäßes Verfahren, wobei das fließfähige verfestigbare Material zu einem Elastomer verfestigt oder teilverfestigt werden kann. Verfestigen oder auch Teilverfestigen bedeutet jeweils eine Erhöhung der Viskosität gegebenenfalls bis zu dem Punkt, wo ein Festkörper vorliegt. Bevorzugte Materialien, die zu einem Elastomer verfestigt können sind: Kautschuk, organische Elastomere, Silikonelastomere bzw. deren Vorstufen.

Bevorzugt ist ein erfindungsgemäßes Verfahren, wobei der erste Gegenstand ein Wafer oder eine Glasplatte ist und/oder der zweite Gegenstand ein Wafer ist.

Bei den Wafern kann es sich bevorzugt um Siliziumwafer handeln, die gegebenenfalls dotiert sind. Auch Wafer aus AlSb, AlAs, AlN, AlP, BN, BP, BAs, GaSb, GaAs, GaN, GaP, InSb, InAs, InN, InP können für viele Anwendungen bevorzugt sein. Als Glasplatte ist bevorzugt folgendes Material: Borosilikatglas oder Quartzglas.

Wie bereits oben angedeutet, ist erfindungsgemäß bevorzugt ein Verfahren, wobei die das Kontaktieren im Schritt f) bewirkende Kraft die Erdanziehung ist. In diesem Falle wird wie beschrieben die zweite Fläche der umlaufenden Aufwölbung angenähert und gegebenenfalls lateral ausgerichtet. Dann wird die Halterung des zweiten Gegenstandes gelöst oder die haltende Kraft (wie zum Beispiel eine elektrostatische Kraft) aufgehoben. Dies führt dazu, dass der zweite Gegenstand durch die Erdanziehungskraft beschleunigt auf die umlaufende Aufwölbung fällt. Die Fallhöhe passt der Fachmann so an, dass ein abgeschlossener Hohlraum entsteht und bevorzugt die umlaufende Aufwölbung nicht vollständig nivelliert wird. Vorteil an diesem bevorzugten Verfahren ist, dass mit geringem apparativem Aufwand und hoher Genauigkeit das Kontaktieren im Schritt f) gewährleistet werden kann.

Bevorzugt ist erfindungsgemäß darüber hinaus ein Verfahren, wobei im Schritt f) (gegebenenfalls zur Gewichtskraft des zweiten Gegenstandes) eine Kraft von maximal 100 Newton auf die Aufwölbung ausgeübt wird , bevorzugt 10 N, weiter bevorzugt 1 N.

Bevorzugt ist ein erfindungsgemäßes Verfahren, wobei der zweite Gegenstand ein Wafer mit elektronischen Bauteilen ist, die auf der zu der zweiten Fläche ausgerichteten Seite des Wafers sind oder die zweite Fläche bilden.

Im Sinne der Erfindung kann der Wafer selbstverständlich auch weitere Schichten wie zum Beispiel Passivierungsschichten auf den elektronischen Bauteilen umfassen.

Bei einer besonders bevorzugten Ausgestaltung der Erfindung wird die zweite Fläche durch eine Passivierungsschicht oder eine Trennschicht gebildet.

Bevorzugt sind für die Trennschicht plasmapolymere Schichten, die eventuell als Gradientenschicht ausgestaltet sind. Mit Hilfe dieser Trennschicht ist es möglich, die gewünschte Haftkraft besonders vorteilhaft einzustellen. Geeignete Trennschichten sind in der WO 2007/099146 beschrieben, die voll umfänglich auf dem Wege der Verweisung Bestandteil dieser Anmeldung wird. Insbesondere Bestandteil dieser Anmeldung werden die Teile, die die Ausgestaltung der Trennschicht beschreiben. Ebenfalls auf dem Wege der Verweisung wird Bestandteil dieser Anmeldung die WO 2004/051708, die ebenfalls Angaben über geeignete Trennschichten enthält. Insbesondere diese Angaben werden auf dem Wege der Verweisung Bestandteil dieser Anmeldung.

Darüber hinaus finden sich Angaben zu der Ausgestaltung der Zwischenschicht als Elastomerschicht ebenfalls in der WO 2007/099146, wobei auch diese Angaben auf dem Wege der Verweisung explizit Bestandteil dieser Anmeldung werden.

Bevorzugt ist ein erfindungsgemäßes Verfahren, wobei die Trennschicht so ausgestaltet ist, dass sie nach dem Aushärten der Zwischenschicht an dieser fester haftet als am Wafer.

Die Haftfestigkeit zwischen den jeweiligen Schichten kann der Fachmann nach der DIN 971-1: 1996-09 bestimmen und sie wird definiert als "Gesamtheit der Bindekräfte zwischen einer Beschichtung und ihrem Untergrund".

Nachfolgend wird die Erfindung anhand einer Figur und eines Beispiels beispielhaft beschrieben, wobei beides nur der näheren Erläuterung und nicht der Einschränkung der Erfindung dienen soll.

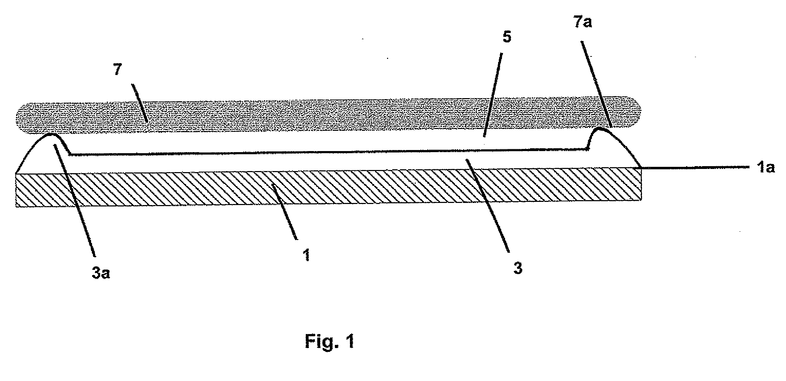

Die Figur 1 stellt dar einen ersten Gegenstand 1 mit einer ersten Fläche 1a, der im nachfolgenden Beispiel einer Glasplatte entspricht. Das Material für die Zwischenschicht 3 wurde auf die Fläche 1a so aufgebracht, dass eine umlaufende Aufwölbung 3a entstanden ist. Auf diese umlaufende Aufwölbung 3a wurde ein zweiter Gegenstand 7 mit einer zweiten Fläche 7a so aufgelegt, dass ein abgeschlossener Hohlraum 5 entstanden ist. Der zweite Gegenstand 7 entspricht im nachfolgenden Beispiel einem Siliziumwafer an dessen Vorderseite elektronische Strukturen aufgebracht worden sind und umfasst auch eine Trennschicht, die die zweite Fläche 7a bildet.

### Beispiel

Ein 6" großer Siliziumwafer, auf dessen Vorderseite die elektrischen Strukturen fertig aufgebracht worden sind und durch eine Schutzschicht (Passivierung) aus Nitrid geschützt werden, soll für das Abdünnen von seiner Ursprungsdicke von ca. 750 µm auf eine Dicke von 50 µm vorbereitet werden. Bei einer Restdicke von 50 µm verliert der Wafer seine mechanische Eigenstabilität und wird sehr fragil. Um die hieraus resultierende hohe Bruchgefahr zu vermeiden, soll der Wafer temporär mittels eines Trägers so verstärkt werden, dass er auch im gedünnten Zustand im Wesentlichen die mechanische Stabilität eines nicht gedünnten Wafers besitzt. Dazu wird der Träger auf der Vorderseite des Wafers und damit seine strukturierte Seite aufgebondet. Die gegenüberliegende Seite des Wafers soll zum Zwecke des Dünnens geschliffen werden.

Zur Vorbereitung des Bonden mit dem Träger, wurde auf der Vorderseite des zu dünnenden Wafers eine plasmapolymere Trennschicht mittels PECVD aufgebracht, die ein späteres Ablösen des Trägers wieder ermöglichen soll. Dieser Vorgang ist z. B. in der WO 2007/099146 beschrieben.

Der Träger besteht aus einer Glasplatte - wobei alternativ hierzu auch ein Siliziumwafer verwendet werden kann - die in ihrem Durchmesser dem zu dünnenden Wafer entspricht oder 1 - 2 mm größer ist. Auf diese Glasplatte wird ein flüssiges und noch nicht vernetztes Silikon-Elastomer mit einer Viskosität von 500 mPa s mittels Spincoating aufgebracht. Hierbei wird die Glasplatte in eine Anlage verbracht und auf einer Halterung fixiert. Diese Halterung wird motorisch in Rotation versetzt, wobei die Anzahl der Umdrehungen pro Minute geregelt werden kann.

Die Glasplatte wird zunächst auf 300 Umdrehungen pro Minute gebracht. Nach Erreichen dieser Umdrehungsgeschwindigkeit wird mittels einer Düse eine Menge von 10 ml des Elastomers exakt auf die Mitte der sich drehenden Glasplatte aufgebracht. Auf Grund der von der Umdrehungsgeschwindigkeit herzuleitenden Fliehkräfte wird nun das Elastomer zum Rand der Glasplatte getrieben. Mit einer Viskosität von beispielhaft 500 mPa s ist das Elastomer hinreichend fließfähig, um die Fläche der Glasplatte vollflächig zu benetzen. Um dieses zu unterstützen, kann für einen kurzen Zeitraum auch die Umdrehungsgeschwindigkeit von 300 auf zum Beispiel 1000 Umdrehungen pro Minute erhöht werden. Durch geeignete Wahl der Produkteigenschaften des Elastomers (z.B. der Viskosität) und durch die Einstellung der Prozessparameter (Umdrehungsgeschwindigkeit, Zeitdauer etc.) kann dieser Prozess so eingestellt werden, dass sich auf der Glasplatte vollflächig eine Beschichtung ergibt, die in ihrer Dickentoleranz innerhalb von 10 µm und reproduzierbar zum Beispiel eine absolute Dicke von 150 µm besitzt.

Das aufgeschleuderte Material bildet dabei eine umlaufende Aufwölbung am Rand der Glasplatte aus. Diese besitzt eine Höhe von ca. 50 µm und eine Breite von 1 - 2 mm.

Um jetzt den Wafer und den Träger - in Form der mit Elastomer beschichteten Glasplatte - miteinander zu verbinden, wird beides in eine Anlage gebracht, die eine Kammer besitzt, welche unter Vakuum gesetzt werden kann.

Zunächst einmal wird die Glasplatte so fixiert, dass deren beschichtete Seite nach oben zeigt. Danach wird der zu dünnende Wafer mit der strukturierten Seite nach unten ca. 4 mm über der Glasplatte so positioniert, dass Wafer und Glasplatte zueinander lateral in Deckung sind. Der Wafer wird hierbei seitlich von kleinen Auflagen positioniert und gehalten.

Nachdem nunmehr Wafer und Träger in der Anlage fixiert sind, wird die sie umschließende Kammer durch Abpumpen unter ein Vakuum gesetzt, das einem Vakuum von 0,1 mbar entspricht. Nachdem dieses Vakuum erreicht ist, werden die Halterungen des Wafers weggezogen, so dass dieser nach unten fällt und auf der beschichteten Glasplatte zum Liegen kommt. Durch die kreisrunde Aufwölbung am Rand der Glasplatte ergibt es sich, dass hierbei der Wafer zunächst nur auf der Erhöhung der Aufwölbung aufliegt. Somit bildet sich ein vakuumgefüllter Leerraum zwischen Wafer und Träger. Durch das nachfolgende Belüften der Kammer lastet auf diesem Leerraum der atmosphärische Luftdruck. Damit wird der Leerraum zusammenpresst und somit auch Wafer und Träger. Durch den entstehenden Druck und der Eigenstabilität der Glasscheibe wird auch die Aufwölbung des Elastomers verpresst, so dass ein Formschluss entsteht.

Nachfolgend wird das Elastomer vernetzt, indem die Halterung erhitzt wird, auf der die Glasplatte aufliegt. Durch die gezielte Einstellung der Temperatur und der Zeit können hierbei unterschiedliche Vernetztungsgrade erzielt werden werden. Nachdem dieses erfolgt ist, kann der entstandene Verbund aus Wafer und Träger der Anlage entnommen werden. Hierbei wird eine exakte Parallelität der Ausrichtung von Wafer und Träger erzielt.

## Patentansprüche

1. Verfahren zum Bonden einer ersten Fläche (1a) und einer zweiten Fläche (7a) mittels einer Zwischenschicht (3), umfassend die Schritte:
a) Bereitstellen eines ersten Gegenstandes (1) mit der ersten Fläche (1a),
b) Bereitstellen von fließfähigem, verfestigbarem Material für die Zwischenschicht (3),
c) Bereitstellen eines zweiten Gegenstandes (7) mit der zweiten Fläche (7a),
d) Auftragen des Materials für die Zwischenschicht auf die erste Fläche (1a), so dass eine die Fläche umlaufende Aufwölbung (3a) entsteht,
e) Anlegen eines Vakuums um den ersten Gegenstand (1) und den zweiten Gegenstand (2),
f) Kontaktieren der zweiten Fläche (7a) des zweiten Gegenstandes (7) mit der umlaufenden Aufwölbung, so dass ein abgeschlossener Hohlraum (5) entsteht,
g) Erhöhen des Umgebungsdruckes, so dass der Hohlraum (5) aufgehoben wird, ohne dass es zu einem Gaseinstrom in ihn kommt und
h) Erhöhen der Viskosität des Materials für die Zwischenschicht.

2. Verfahren nach Anspruch 1, wobei das fließfähige verfestigbare Material ein polymerisierbares Material ist.

3. Verfahren nach Anspruch 1 oder 2, wobei das fließfähige verfestigbare Material zu einem Elastomer verfestigt werden kann.

4. Verfahren nach einem der vorangehenden Ansprüche, wobei der erste Gegenstand (1) ein Wafer oder eine Glasplatte ist und/oder der zweite Gegenstand (7) ein Wafer ist.

5. Verfahren nach einem der vorangehenden Ansprüche, wobei die das Kontaktieren im Schritt f) bewirkende Kraft die Erdanziehung ist.

6. Verfahren nach einem der vorangehenden Ansprüche, wobei beim Schritt f) gegebenenfalls zusätzlich zur Gewichtskraft des zweiten Gegenstandes eine Kraft von maximal 100 N auf die Aufwölbung (3a) ausgeübt wird.

7. Verfahren nach einem der vorangehenden Ansprüche, wobei der zweite Gegenstand (7) ein Wafer mit elektronischen Bauteilen ist, die auf der zu der zweiten Fläche (7a) ausgerichteten Seite des Wafers sind oder diese bilden.

8. Verfahren nach Anspruch 7, wobei die zweite Fläche (7a) durch eine Passivierungsschicht oder eine Trennschicht gebildet wird.

9. Verfahren nach Anspruch 8, wobei die Trennschicht eine plasmapolymere Schicht ist.

10. Verfahren nach Anspruch 8 oder 9, wobei die Trennschicht so ausgestaltet ist, dass sie nach dem Aushärten der Zwischenschicht an dieser fester haftet als am Wafer.

## Claims

1. A method for bonding a first surface (1a) and a second surface (7a) by means of an interlayer (3), comprising the steps:
a) providing a first item (1) which has the first surface (1 a),
b) providing flowable, solidifiable material for the interlayer (3),
c) providing a second item (7) which has the second surface (7a),
d) applying the material for the interlayer onto the first surface (1 a) so that a bulge (3a) encircling the surface is produced,
e) applying a vacuum around the first item (1) and the second item (2),
f) bringing the second surface (7a) of the second item (7) into contact with the circumferential bulge so that a sealed-off cavity (5) is produced,
g) increasing the ambient pressure so that the cavity (5) is eliminated without resulting in a stream of gas flowing into the cavity and
h) increasing the viscosity of the material for the interlayer.

2. The method as claimed in claim 1, wherein the flowable, solidifiable material is a polymerizable material.

3. The method as claimed in either claim 1 or claim 2, wherein the flowable, solidifiable material can be solidified to produce an elastomer.

4. The method as claimed in any one of the preceding claims, wherein the first item (1) is a wafer or a glass pane and/or the second item (7) is a wafer.

5. The method as claimed in any one of the preceding claims, wherein the force causing the contacting in step f) is gravity.

6. The method as claimed in any one of the preceding claims, wherein in step f), a maximum force of 100 N is exerted on the bulge (3a), if appropriate in addition to the weight of the second item.

7. The method as claimed in any one of the preceding claims, wherein the second item (7) is a wafer with electronic components which are on the side of the wafer oriented towards the second surface (7a) or they form this second surface.

8. The method as claimed in claim 7, wherein the second surface (7a) is formed by a passivation layer or a separation layer.

9. The method as claimed in claim 8, wherein the separation layer is a plasmapolymeric layer.

10. The method as claimed in either claim 8 or claim 9, wherein the separation layer is configured such that after the interlayer has cured, the separation layer adheres more firmly to the interlayer than to the wafer.

## Revendications

1. Procédé de liaison d'une première surface (1a) et d'une deuxième surface (7a) au moyen d'une couche intermédiaire (3), comprenant les étapes consistant à :
a) fournir un premier objet (1) comprenant la première surface (1a) ;
b) fournir un matériau apte à l'écoulement, pouvant se solidifier pour la couche intermédiaire (3) ;
c) fournir un deuxième objet (7) comprenant la deuxième surface (7a) ;
d) appliquer le matériau pour la couche intermédiaire sur la première surface (1a) de manière à faire apparaître un bombement (3a) s'étendant sur le pourtour de la surface ;
e) faire un vide autour du premier objet (1) et du deuxième objet (2) ;
f) établir un contact entre la deuxième surface (7a) du deuxième objet (7) et le bombement périphérique de manière à faire apparaître un espace creux (5) fermé ;
g) augmenter la pression environnante de manière à faire monter l'espace creux (5) sans donner lieu à un afflux entrant de gaz dans l'espace creux ; et
h) augmenter la viscosité du matériau pour la couche intermédiaire.

2. Procédé selon la revendication 1, le matériau apte à l'écoulement pouvant se solidifier étant un matériau polymérisable.

3. Procédé selon la revendication 1 ou 2, le matériau apte à l'écoulement pouvant se solidifier pouvant être solidifié de manière à former un élastomère.

4. Procédé selon l'une quelconque des revendications précédentes, le premier objet (1) étant une tranche ou une plaque de verre et/ou le deuxième objet (7) étant une tranche.

5. Procédé selon l'une quelconque des revendications précédentes, la force provoquant l'établissement du contact à l'étape f) étant l'attraction terrestre.

6. Procédé selon l'une quelconque des revendications précédentes, une force de maximum 100 N étant exercée lors de l'étape f), éventuellement en plus de la force de la pesanteur du deuxième objet, sur le bombement (3a).

7. Procédé selon l'une quelconque des revendications précédentes, le deuxième objet (7) étant une tranche comprenant des composants électroniques, qui sont sur le côté, orienté vers la deuxième surface (7a), de la tranche ou qui forment ledit côté.

8. Procédé selon la revendication 7, la deuxième surface (7a) étant formée par une couche de passivation ou par une couche de séparation.

9. Procédé selon la revendication 8, la couche de séparation étant une couche de polymère plasma.

10. Procédé selon la revendication 8 ou 9, la couche de séparation étant configurée de telle sorte qu'elle adhère plus solidement au niveau de la couche intermédiaire qu'au niveau de la tranche après le durcissement de la couche intermédiaire.
